# EUROPEAN PATENT APPLICATION

(11) **EP 4 108 512 A1**
(43) Date of publication of application: **28.12.2022**
(21) Application number: 21464002.1
(22) Date of filing: 29.09.2021
(51) Int. Cl.: B60L 53/30, B60L 53/16, B60L 53/18, B60L 53/66, B60L 53/10, B60L 3/12, G01R 31/50, H01R 13/42, H01R 13/426, H01R 13/447, H01R 13/46

(54) **EXTENSION DEVICE FOR THE DIAGNOSIS OF CONDUCTIVE CHARGING SYSTEMS**

(30) Priority: 25.06.2021 RO 202100368
(71) Applicant: Stefan cel Mare University of Suceava, 720229 Suceava, County Suceava (RO)
(72) Inventor: Bejenar, Ciprian, mun. Suceava, jud. Suceava (RO); Bejenar, Marian, mun. Suceava, jud. Suceava (RO); Dimian, Mihai, mun. Suceava, jud. Suceava (RO); Milici, Dan Laurentiu, sat Lisaura, com. Ipotesti, jud. Suceava (RO); Milici, Mariana Rodica, sat Lisaura, com. Ipotesti, jud. Suceava (RO); Afanasov, Ciprian, sat Lipoveni, com. Mitocu Dragomirnei, jud. Suceava (RO); Ungureanu, Constantin, mun. Suceava, jud. Suceava (RO); Paval, Mihaela, sat Valea Putnei, com. Pojorita, jud. Suceava (RO)

(57) **Abstract**

***Summary:*** Extension device for the diagnosis of conductive charging systems, according to the invention, it consists mainly of a monobloc body (1) which can be attached to a handle (2), for attachment to a charging plug which can be inserted and interlocked at the entrance to the input port (4) and which, for the purpose of their extension, is provided at output with an output plug (5) for which it can be further inserted manually and/or automated (assisted and/or autonomous) without being interlocked in the corresponding charging port of an electric vehicle powered through it, and which also, in order to facilitate monitoring of the supply process, it is provided at the input with an universal power port (6), necessary to attach an external source of electrical energy for the purpose of supplying as the case may be, of electrical circuits and/or active sensors and at the same time, for the purpose of diagnosis through monitoring of the supply process of an electric vehicle, in its composition, the monobloc body (1) is provided with an electrical circuit connected as the case may be, directly or indirectly to the involved conductors involved, by means of resistors and/or passive current sensors and/or active current sensors, whose signals corresponding to the electrical parameters of interest are supplied and available at the output of universal terminals (13) and groupable in the acquisition blocks (14'), (14"), (14‴), (14ʺʺ), (14‴ʺ), (14‴‴), configurable and adaptable.

The summary of the invention will be published together with figure 1.

## Description

The invention relates to a device for the diagnosing of conductive charging systems for powering electric vehicles, suitable as an accessory to equipment and/or systems for data acquisition and/or for testing.

In the purpose of the diagnosis of conductive charging systems for powering electric vehicles, a solution is known (WO2012078921) which consists, mainly, in involving an extension cable as an accessory to an equipment and/or system for testing charging systems for powering electric vehicles.

Some of the disadvantages of the described solution are related to that it is constructively complex due to the multiple elements (segments) of which it is composed, it can be attached in the purpose of the diagnosis only in the extension of simple conductive charging systems (in direct current), it is suitable as an accessory for a specific equipment and/or specific system for testing, so it does not allow testing in its absence, but also in the absence of an incorporable source of electrical energy and/or of universal terminals and which also, it requires strictly a human operator to operate the system for interlocking the output plug in the supply port, which makes the extension action difficult.

The invention solves, mainly, a technical problem by which it uses a simple solution from a constructive point of view and allows it to be attached for diagnostic purposes in the extension of any conductive charging system, it is suitable as an accessory regardless of the equipment and/or the system for testing and it has the ability to incorporate an incorporable source of electrical energy and/or universal terminals, without the strict need for a human operator, which facilitates the extension action.

Extension device for the diagnosis of conductive charging systems, according to the invention, it surprises the presented disadvantages and problems in that it assumes, mainly, a body with a unitary construction, extensible and attachable between the charging plug of any conductive charging system and the corresponding charging port of an electric vehicle that is powered through it, by manual operation and/or automated (assisted and/or autonomous), so that, depending on the construction variant, it allows easy electrical access to the charging system conductors because of the universal terminals that it disposes of, to which any equipment and/or systems for data acquisition and/or testing can be connected without limitation, because the device constitutes a monobloc testing probe for the acquisition of the related signals corresponding to the electrical parameters of interest, which may dispose as the case may be of an external source of electrical energy or an incorporable source of electrical energy.

The invention has the following advantages:
- The device simplifies construction and extends the functionalities of the existing technical solution;
- The device allows facile electrical access to the conductors involved in the process of powering an electric vehicle;
- The device can be compatible with several variants of conductive charging systems, plugs and ports for powering electric vehicles;
- The device can have several constructive variants, depending on the imposed diagnostic needs;
- The device allows the acquisition of data and/or testing of a conductive charging system regardless of the equipment and/or system for acquisition and/or testing involved;
- The device does not strictly require a human operator in order to be manipulated for the diagnosis of conductive charging systems for powering electric vehicles;
- The device can be easily attached in automated (assisted and/or autonomous) acquisition and/or testing systems;
- The device facilitates and introduces extensive possibilities for data acquisition, study, diagnosis and testing of conductive charging systems for powering electric vehicles.

Below is further given an embodiment of the invention in connection with the following figures:

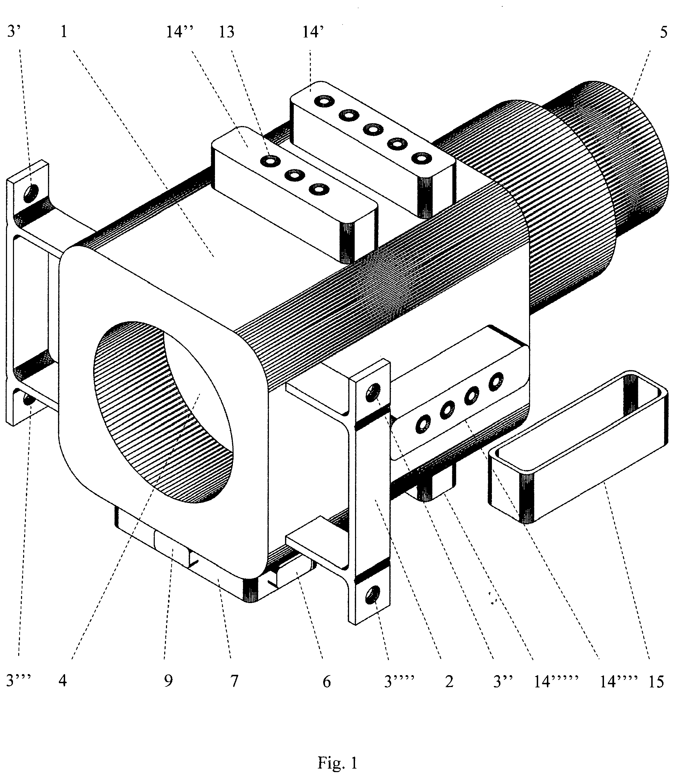

- Fig. 1 - Extension device (combined variant) for the diagnosis of combined conductive charging systems, front view;

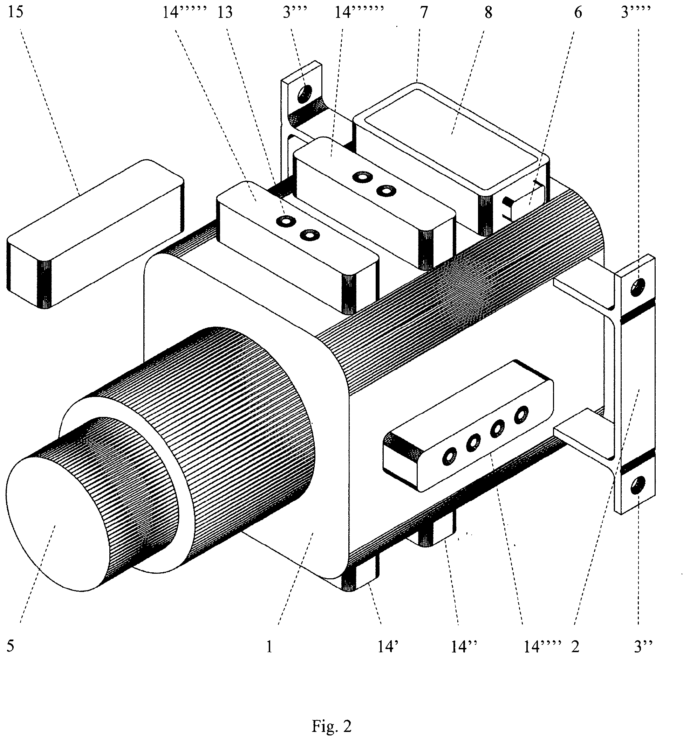

- Fig. 2 - Extension device (combined variant) for the diagnosis of combined conductive charging systems, rear view;

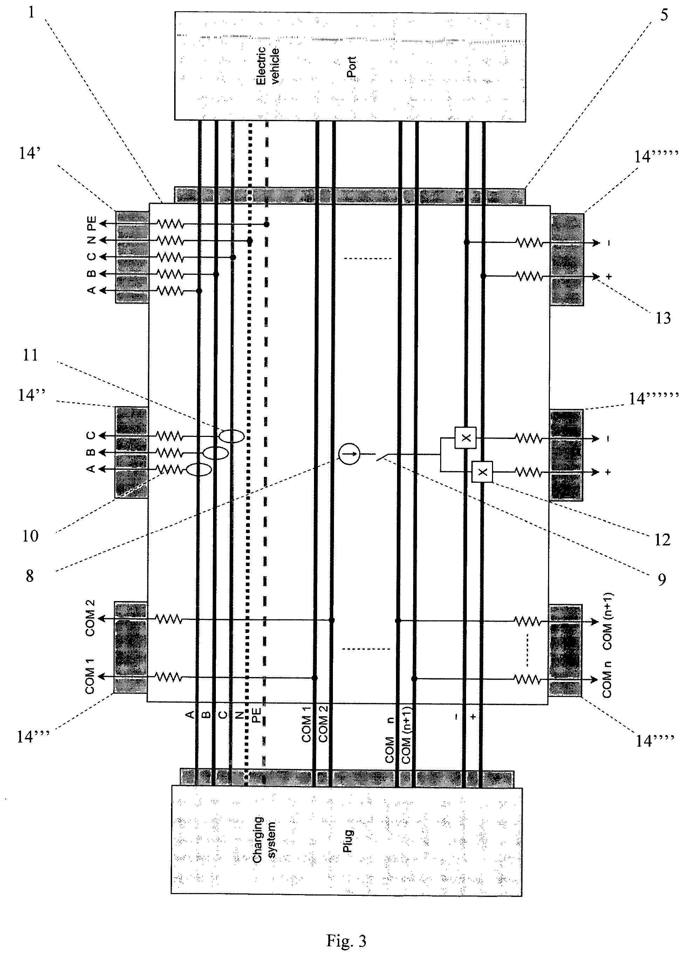

- Fig. 3 - Electrical diagram of the extension device (combined variant) for the diagnosis of combined conductive charging systems.

The invention consists of a device for the diagnosis of conductive charging systems for powering electric vehicles, suitable as an accessory to equipment and/or systems for data acquisition and/or for testing, which consists of a monobloc body 1 which can be attached to a handle 2 provided with flanges 3', 3", 3"', 3"", for attachment to a charging plug which can be inserted and interlocked at the entrance to the input port 4 and which, for the purpose of their extension, is provided at output with an output plug 5 for which it can be further inserted manually and/or automated (assisted and/or autonomous) without being interlocked in the corresponding charging port of an electric vehicle powered through it, and which also, in order to facilitate monitoring of the supply process, it is provided at the input with an universal power port 6, necessary to attach either an external source of electrical energy, and with a protective compartment 7, to attach a continuous source of electrical energy 8, incorporable and detachable, for the purpose of supplying as the case may be, of electrical circuits and/or active sensors through the power button 9 and at the same time, for the purpose of diagnosis through monitoring of the supply process of an electric vehicle, in its composition, the monobloc body 1 is provided with an electrical circuit connected as the case may be, directly or indirectly to the conductors involved (A, B, C, N, PE, COM 1, COM 2, COM n, COM n+1, +, -, etc.), by means of resistors 10 and/or passive current sensors 11 and/or active current sensors 12, whose signals corresponding to the electrical parameters of interest are supplied and available at the output of universal terminals 13 and groupable in the acquisition blocks 14', 14", 14"', 14"", 14""', 14""", configurable, which can be adapted to any equipment and/or system of acquisition and/or for testing through related connection elements, for which its construction involves and is accompanied by head protective caps 15, with a corresponding shape.

Due to the flexibility of its construction, device for the diagnosis of conductive charging systems for powering electric vehicles can be made in several constructive variants (simple or combined), according to the type of the charging system (simple or combined) and to the type of power supply (in alternating current and/or in direct current) which it extends, respectively, in accordance with the plugs and ports of the conductive charging system to which it will be attached, so that it may present a variable number of terminals 13 and acquisition blocks 14', 14", 14"', 14"", 14""', 14""", grouped and configured accordingly, for either on and as many (n, n+1, etc.) it would be the conductors involved and the electrical parameters of interest (by limiting to electrical voltages and/or electric currents and/or communication signals) to be monitored and the related signals provided and available, by changing as needed the input port 4, the output plug 5 and/or of the number of resistors 10 and/or of passive current sensors 11 and/or of active current sensors 12 it disposes of, for the defined purpose. When not in use, for the protection of the supply port 6, the supply button 9, the terminals 13 and the acquisition blocks 14', 14", 14'", 14"", 14""', 14""", as parts of the device for the diagnosis of conductive charging systems for powering electric vehicles, the protective caps 15 are placed on the exposed and unused contacts.

Extension device for the diagnosis of conductive charging systems, according to the invention, does not influence or limit conductive charging systems for powering electric vehicles.

Extension device for the diagnosis of conductive charging systems, according to the invention, can be reproduced with the same performances and characteristics whenever is necessary, which denotes industrial applicability.

## Claims

1. Extension device for the diagnosis of conductive charging systems, **characterized by** that it is made of a monobloc body (1) which can be attached to a handle (2) provided with flanges (3'), (3"), (3"'), (3""), for attachment to a charging plug which can be inserted and interlocked at the entrance to the input port (4) and which, for the purpose of their extension, is provided at output with an output plug (5) for which it can be further inserted manually and/or automated (assisted and/or autonomous) without being interlocked in the corresponding charging port of an electric vehicle powered through it, and which also, in order to facilitate monitoring of the supply process, it is provided at the input with an universal power port (6), necessary to attach either an external source of electrical energy, and with a protective compartment (7), to attach a continuous source of electrical energy (8), incorporable and detachable, for the purpose of supplying as the case may be, of electrical circuits and/or active sensors through the power button (9) and at the same time, for the purpose of diagnosis through monitoring of the supply process of an electric vehicle, in its composition, the monobloc body (1) is provided with an electrical circuit connected as the case may be, directly or indirectly to the conductors involved (A, B, C, N, PE, COM 1, COM 2, COM n, COM n+1, +, -, etc.), by means of resistors (10) and/or passive current sensors (11) and/or active current sensors (12), whose signals corresponding to the electrical parameters of interest are supplied and available at the output of universal terminals (13) and groupable in the acquisition blocks (14'), (14"), (14'''), (14""), (14'""), (14"""), configurable, which can be adapted to any equipment and/or system of acquisition and/or for testing through related connection elements, for which its construction involves and is accompanied by head protective caps (15), with a corresponding shape.

2. Extension device for the diagnosis of conductive charging systems, **characterized by** that it uses a simple solution from a constructive point of view and allows it to be attached for diagnostic purposes in the extension of any conductive charging system, it is suitable as an accessory regardless of the equipment and/or the system for testing and it has the ability to incorporate an incorporable source of electrical energy and/or universal terminals, without the strict need for a human operator, which facilitates the extension action.
